# EUROPÄISCHE PATENTSCHRIFT

(11) **EP 0 878 091 B1**
(45) Veröffentlichungstag und Bekanntmachung des Hinweises auf die Patenterteilung: **11.09.2002**
(21) Anmeldenummer: 97948835.0
(22) Anmeldetag: 30.10.1997
(51) Int. Cl.: H04N 3/15, H04N 9/04, H01L 27/146

(54) **FARBBILDSENSOR FÜR KURZZEITBELICHTUNG**
COLOUR IMAGE SENSOR FOR SHORT-TIME EXPOSURE
CAPTEUR D'IMAGE COULEUR POUR EXPOSITION DE COURTE DUREE

(30) Priorität: 31.10.1996 DE 19643972
(43) Veröffentlichungstag der Anmeldung: 18.11.1998
(73) Patentinhaber: Böhm, Markus, Prof. Dr.-Ing., 57068 Siegen (DE)
(72) Erfinder: BÖHM, Markus, Universität-Gesamthochschule Siegen, D-57068 Siegen (DE); RIEVE, Peter, D-51570 Windeck-Dattenfeld (DE); LULE, Tarek, D-57076 Siegen (DE)
(74) Vertreter: Schippan, Ralph, Dr.-Ing.
(86) Internationale Anmeldenummer: EP9705978
(87) Internationale Veröffentlichungsnummer: WO98019455

(56) Entgegenhaltungen:
- EP-A- 0 603 877
- EP-A- 0 774 870
- WO-A-96/13865
- US-A- 4 989 075

## Beschreibung

Die Erfindung betrifft einen optischen Sensor bestehend aus einer Anordnung von Bildpunkteinheiten, die jeweils einen optoelektronischen Wandler zum Umwandeln der einfallenden Strahlung in einen intensitäts- und wellenlängenabhängigen Photostrom, ein Integratormittel zur Gewinnung eines dem erfaßten Photostrom entsprechenden Meßwertes und ein steuerbares Speichermittel zur Abspeicherung des Meßwertes umfassen und aus einer Auslesesteuereinrichtung für das jeweils auf eine Bildpunkteinheit bezogene Auslesen der abgespeicherten Meßwerte , wobei aus den bildpunkteinheitbezogenen Meßwerten das auf den Sensor eingestrahlte Bild zusammensetzbar ist.

Optische Sensoren haben die Aufgabe, eine Bildszene aufzunehmen und in elektrische Signale umzuwandeln derart, daß mehrere Teilbilder erzeugt werden, die sich in der Gewichtung der verschiedenen von der Szene ausgestrahlten Spektralanteile unterscheiden. Für den sichtbaren Spektralbereich erweist sich insbesondere die Zerlegung in den blauen, grünen und roten Spektralbereich als sehr vorteilhaft, da diese spektrale Gewichtung eine dem menschlichen Auge angepaßte farbige Wiedergabe von Bildszenen ermöglicht.

Bekannte (A.J.P. Theuwissen, Solid-State Imaging with Charge-Coupled Devices, Kluwer Academic Publishers, Dordrecht, Kap. 6.2, S.2, S.165ff., 1995) farbauflösende Bildsensoren zeichnen sich dadurch aus, daß für jeden Bildpunkt mehr als ein Signal detektiert werden muß. In der Regel wird entsprechend den drei Farbanteilen Rot, Grün und Blau eine Dreiteilung vorgenommen. Erst diese Farbsignale zusammengenommen ergeben die komplette Farbinformation eines Bildpunktes, die sich beispielsweise im Rahmen einer Signalübertragungsstrecke aus den drei linear unabhängigen Einzelsignalen reproduzieren läßt.

Technisch existieren mehrere Möglichkeiten zur Realisierung der genannten Farbauflösung. Die Verfahren zur Erzeugung der spektral gewichteten Teilbilder lassen sich grob in zwei Typen unterteilen. Der erste Typ solcher farbbildgebender Verfahren (A.J.P. Theuwissen, Solid-State Imaging with Charge-Coupled Devices, Kluwer Academic Publishers, Dordrecht, Kap. 6.2.4, S. 171 ff., 1995) verwendet mehrere Bildsensoren, deren spektrale Empfindlichkeiten sich durch das Einbringen von Farbfiltern in die jeweiligen Strahlengänge der einzelnen Sensoren unterscheiden. Diesem Verfahren haftet der Nachteil an, daß die einzelnen Strahlengänge so justiert werden müssen, daß sie zu völlig identischen Abbildungen der Szene auf den Bildsensoren führen, da die rekonstruierten Farb-Teilbilder sonst nicht deckungsgleich kombiniert werden können, was Farbverzerrungen nach sich zieht.

Der zweite existierende Typ farbbildgebender Verfahren (A.J.P. Theuwissen, Solid-State Imaging with Charge-Coupled Devices, Kluwer Academic Publishers, Dordrecht, Kap. 6.2.2, S.168ff, 1995)verwendet spezielle Farbbildsensoren, bei denen durch mosaikartiges Aufbringen mehrerer Farbfilter jeweils benachbarte Pixel für unterschiedliche Spektralbereiche empfindlich gemacht werden. Während die Farb-Teilbilder dieser Sensoren auf diese Art und Weise automatisch kongruent zueinander sind, sinkt bei diesem Verfahren die effektive Auflösung um den Faktor drei bis vier, da jeweils drei bzw. vier benachbarte Sensorpixel benötigt werden, um die komplette Farbinformation eines Bildpunktes zu extrahieren.

Ferner ist eine Kombination aus den zuvor beschriebenen Typen möglich (A.J.P. Theuwissen, Solid-State Imaging with Charge-Coupled Devices, Kluwer Academic Publishers, Dordrecht, Kap. 6.2.4, S. 171ff., 1995), bei der ein Spektralbereich, beispielsweise der Grünanteil, von einem Sensor aufgenommen wird, während die anderen Spektralbereiche, in diesem Beispielsfall Rot- und Blauanteil, von einem Mosaik-Zweifarbsensor aufgenommen wird. Dieser Kompromißlösung haften die Nachteile beider Grundtypen gleichzeitig an, wenn auch in abgeschwächtem Umfang.

Eine Alternative hierzu ist durch die zeitlich sequentielle Aufnahme dreier Teilbilder gegeben, die jeweils den Rot-, Grün- und Blauanteil der dem Bildpunkt zugeordneten Beleuchtung repräsentieren. Hierbei ist unmittelbar nach der Belichtung eines Teilbildes ein Auslesen des kompletten Bildes erforderlich. Mithin werden die drei Farb-Teilbilder jeweils durch die unvermeidbaren Auslesevorgänge zeitlich voneinander getrennt. Die Dauer der Auslesevorgänge ist abhängig von der Pixelanzahl und folglich von der lateralen Auflösung des Bildsensors, so daß im Zuge einer Steigerung von Auflösung und Pixelzahl diesbezüglich mit einer Erhöhung der Auslesezeiten zu rechnen ist. Die jeweils zwischen die Belichtung der Farb-Teilbilder geschalteten Auslesezyklen machen in der Konsequenz die Aufnahmen von Szenen mit bewegtem Bildinhalt unmöglich, da die drei Teilbilder nicht mehr deckungsgleich sind. Überdies gestattet dieser Betriebsmodus eines Farbsensors nicht die Aufnahme eines Farbbildes innerhalb der für die Belichtung zur Verfügung stehenden Abbrennzeit eines Blitzgerätes.

Der Erfindung liegt die Aufgabe zugrunde, einen optischen Sensor zu schaffen, welcher einen Betrieb innerhalb einer kurzen Belichtungszeit gestattet.

Das Problem wird erfindungsgemäß dadurch gelöst, daß der optoelektronische Wandler hinsichtlich seiner spektralen Empfindlichkeit selektiv steuerbar ist, und daß jede Bildpunkteinheit ein Integratormittel und mindestens zwei parallel zueinander angeordnete Speichermittel umfaßt derart, daß während der Meßperiodendauer mindestens zwei, jeweils unterschiedlichen Spektralbereichen der einfallenden Strahlung zugeordnete Meßwerte erfaßbar, abspeicherbar und anschließend gemeinsam zur Bildung der für das Bildpunktelement relevanten Farbinformation auslesbar sind.

Erfindungsgemäß ist jeder der Bildpunkte eines Farbsensors mit mehreren Speicherzellen ausgestattet, welche eine Zwischenspeicherung der Farbanteile ermöglichen. Auf diese Weise können mehrere den einzelnen Farbanteilen entsprechende Teilbilder nacheinander aufgenommen werden, ohne daß nach Belichtung eines Teilbildes die Information des kompletten Bildsensors ausgelesen werden muß. Die zeitintensiven Auslesevorgänge können nunmehr an das Ende des gesamten Belichtungszyklus, bestehend aus mehreren aufeinanderfolgenden Einzelbelichtungen, verlagert werden.

Die erfindungsgemäße Lösung schafft somit einen integrierenden, bildgebenden, optischen, farbsensitiven Bildsensor, bei dem jeder Bildpunkt (Pixel) in jedem Bildfolgezyklus die komplette Farbinformation nach Maßgabe der auf ihn auftreffenden Beleuchtung aufzeichnen und in elektronischer Form bereitstellen kann. Der Sensor ist dabei durch zwei wesentliche Eigenschaften gekennzeichnet: Jeder Bildpunkt der matrixorganisierten Sensorstruktur verfügt über mehrere Informationsspeicher, um die verschiedenen Farbinformationen zwischenspeichern zu können. Des weiteren enthält der Sensor steuerbare Detektorelemente, welche sich in ihrer spektralen Empfindlichkeit verändern lassen. Ein der Erfindung gemäßer Bildsensor ermöglicht somit die Aufzeichnung sämtlicher Farbinformationen einer Bildszene durch unmittelbar aufeinanderfolgende Belichtung der einzelnen Farbanteile, ohne daß zwischen den Einzelbelichtungen ein Auslesevorgang erforderlich ist. Auf diese Weise können kurze Belichtungszeiten bei gleichzeitig unverminderter Auflösung realisiert werden. Insbesondere eignet sich die vorliegende Sensorstruktur beispielsweise zur Aufzeichnung von Farbbildern innerhalb eines einzigen Beleuchtungszyklus eines Kurzzeitbeleuchtungssystems (Blitzgerät).

Ein kompletter Bildzyklus besteht unter Verwendung eines der Erfindung gemäßen Farb-Bildsensors beispielsweise aus folgenden Schritten:
1. Belichtung des ersten Einzelbildes (z. B. rot)
2. Speicherung des ersten Einzelbildes
3. Belichtung des zweiten Einzelbildes (z. B. grün)
4. Speicherung des zweiten Einzelbildes
5. Belichtung des dritten Einzelbildes (z. B. blau)
6. Speicherung des dritten Einzelbildes
7. Auslesen des ersten Einzelbildes
8. Auslesen des zweiten Einzelbildes
9. Auslesen des dritten Einzelbildes.

Die Reihenfolge der Aufzeichnung und Speicherung der zu den Einzelbildern gehörigen Meßwerte sowie deren Auslesen ist prinzipiell beliebig. Belichtung und Speicherung der Einzelbilder können auch gleichzeitig erfolgen.

Der wesentliche Vorteil eines nach diesem Betriebsmodus arbeitenden Farbsensors im Vergleich zu einer Betriebsweise, bei der die Einzelbelichtungen jeweils durch das Auslesen der Einzelbilder unterbrochen werden, besteht in der kurzen Gesamt-Belichtungszeit, welche sich lediglich über die in der obigen Auflistung mit 1. bis 5. numerierten Vorgänge erstreckt, während die zeitintensiven Auslesevorgänge 7. bis 9. nicht mehr der eigentlichen Belichtung zugerechnet werden.

Das Verfahren eignet sich besonders für die Aufzeichnung von Farbbildern unter Verwendung eines Kurzzeitbeleuchtungssystem, z. B. eines Blitzgerätes, wobei die gesamte Belichtung innerhalb eines einzigen Beleuchtungszyklus erfolgen kann. In der Regel entstehen aus der Verlagerung sämtlicher Auslesevorgänge an das Ende eines kompletten Bildzyklus keine Nachteile.

Das Auslesen der verschiedenen Farbinformationen muß nicht notwendigerweise zeitlich nacheinander erfolgen, sondern kann bei entsprechender Konfiguration des Sensors in Form von mehreren parallelen Ausleseleitungen auch zeitgleich erfolgen, so daß sich die Dauer des Auslesevorgangs verkürzt.

Eine bevorzugte Ausführungsform eines der Erfindung gemäßen Farbbildsensors sieht die Realisierung der beschriebenen Sensorfunktion innerhalb eines optischen Sensorsystems in **T**hin **F**ilm on **A**SIC (TFA)-Technologie vor. Ein TFA-Bildsensor besteht aus einer optisch aktiven Detektorschicht in Form einer Dünnschichtstruktur, welche vertikal auf einem integrierten Schaltkreis, beispielsweise einem ASIC (**A**pplication **S**pecific **I**ntegrated **C**ircuit) integriert ist. Der ASIC enthält hierbei die matrixorganisierte Pixelstruktur einschließlich der erforderlichen Pixelschaltkreise zur Integration des Photostromes, zur Speicherung der Farbsignale und zu deren Auslese. Der optische Detektor besteht aus einem Mehrschichtsystem auf der Basis amorphen Siliziums, welches über eine mit Hilfe der angelegten elektrischen Spannung steuerbare spektrale Empfindlichkeit verfügt.

Bevorzugt ist vorgesehen, daß der optische Sensor folgenden Schichtenaufbau hat:
(a) eine n-leitende a-Si:H Schicht
(b) eine erste eigenleitende a-Si:H Schicht
(c) eine p-leitende a-Si:H Schicht
(d) eine zweite eigenleitende a-Si:H Schicht, bestehend aus einer ersten Teilschicht mit höherem µ-Tau-Produkt und einer zweiten Teilschicht mit gegenüber der ersten Teilschicht niedrigerem µ-Tau-Produkt eine n-leitende a-Si:H Schicht.

Entsprechend der oben dargestellten nipin-Struktur läßt sich durch Vertauschen von n- und p-leitenden Schichten ebenfalls eine pinip-Struktur herstellen.

Eine besonders gute Eignung für den beschriebenen Farbbildsensor für Kurzzeitbelichtung ergibt sich, wenn folgender Schichtaufbau vorliegt:
(a) eine p-leitende a-Si:H Schicht
(b) eine eigenleitende a-Si:H Schicht bestehend aus drei Teilschichten (I, II, III) unterschiedlicher Dielektrizitätskonstanten, wobei Teilscichten niedriger Dielektrizitätskonstanten jeweils Teilschichten höherer Dielektrizitäzskonstanten in Lichteinfallsrichtung vorgelagert sind
(c) eine n-leitende a-Si:H Schicht

Eine weitere besonders gute Eignung für den beschriebenen Farbbildsensor für Kurzzeitbelichtung ergibt sich, wenn folgender Schichtaufbau vorliegt:
(a) eine p-leitende a-Si:H Schicht
(b) eine eigenleitende a-Si:H Schicht bestehend aus drei Teilschichten unterschiedlicher Dielektrizitätskonstanten, wobei Teilschichten niedriger Dielektrizitätskonstanten jeweils Teilschichten höherer Dielektrizitäzskonstanten in Lichteinfallsrichtung vorgelagert sind
(c) eine p-leitende a-Si:H Schicht.

Hierbei wird eine sogenannte pi³n- bzw. ni³p-Struktur gebildet.

Der Betrieb des Sensors sieht vor, daß nacheinander die verschiedenen, die unterschiedlichen Farbempfindlichkeiten hervorrufenden Detektorspannungen angelegt und die sich einstellenden Photoströme, welche ein Maß für die verschiedenen Farbanteile der auf den betreffenden Bildpunkt auftreffenden Beleuchtung darstellen, im ASIC integriert und in entsprechenden Speicherzellen abgelegt werden. Beispielsweise werden die sich bei drei linear unabhängigen Farbempfindlichkeiten (z. B. rot, grün, blau) einstellenden Photoströme in drei analogen Speicherzellen integriert und gespeichert. Jede der Speicherzellen kann beispielsweise aus einem Kondensator bestehen, auf dem die zeitliche Integration des Photostromes eine zu diesem proportionale Spannung erzeugt, welche dann bis zum Auslesen des Pixels in demselben gespeichert wird. Die drei Kondensatoren können dabei lateral (nebeneinander) oder vertikal (übereinander) im Pixel angeordnet sein. In diesem Zusammenhang können beispielsweise Gatekapazitäten der MOS-Transistoren oder Kapazitäten zwischen verschiedenen Metallisierungsebenen eines ASIC als Speicherzellen verwendet werden. Die ASIC-Technologie erlaubt es damit, mehrere Speicherzellen vertikal übereinander zu realisieren, wodurch sich besonders platzsparende Konfigurationen erzielen lassen. Der wesentliche Vorteil einer derartigen Ausführungsform besteht darin, daß die Speicherkondensatoren im Gegensatz zu mehreren lateral angeordneten Photodetektoren ohne Verlust an Sensorempfindlichkeit verkleinert werden können, so daß auf diese Weise prinzipiell eine höhere Auflösung ohne Einbußen hinsichtlich des Dynamikumfangs erzielbar ist. Mithin kann die gesamte Sensorfläche optisch genutzt werden, da die Speicherzellen vertikal integriert sind und keinen Verlust hinsichtlich des Flächenfüllfaktors nach sich ziehen.

Die Kondensatoren dienen gleichzeitig zur Integration des Photostromes, d. h. zur Umwandlung in ein Spannungssignal, sowie zur Speicherung dieses Spannungssignales. Die Höhe der Spannung ist neben der bereits beschriebenen Abhängigkeit von der Höhe des Photostromes proportional zur Integrationszeit und umgekehrt proportional zur Höhe der Integrationskapazität. Durch die Verwendung von Kondensatoren mit unterschiedlichen Kapazitäten für die Integration der drei Photostromsignale und/oder durch unterschiedliche Wahl der Integrationszeiten können verschiedene Verstärkungen in den einzelnen Farbkanälen erzeugt werden, um auf diese Weise eventuell dem Detektor anhaftende Unterschiede der Farbempfindlichkeiten ausgleichen zu können.

Prinzipiell ist durch einen geeigneten Aufbau der Pixelschaltungen bereits im Sensorpixel eine Umwandlung der Photoströme in digitale Signale möglich, welche dann digital in entsprechenden Speicherzellen abgelegt werden.

Bei der Ausführung eines erfindungsgemäßen Farb-Bildsensors in TFA-Technologie wird die Integration und Speicherung der den Farbanteilen entsprechenden Photostromsignale in mehreren Speicherzellen vorgenommen, welche lateral oder vertikal in jedem Pixel des ASICs integriert sind, wohingegen die Generation der Photoströme selbst mit Hilfe eines farbselektiven und elektrisch steuerbaren optischen Detektors in Dünnschichttechnologie erfolgt, welcher vertikal auf dem ASIC aufgebracht ist.

Eine vorteilhafte Weiterbildung des erfindungsgemäßen Farb-Bildsensors besteht darin, daß jeweils alle Bildpunkte in bezug auf jeden der Farbanteile gleichzeitig belichtet werden. Dieses Verfahren besitzt gegenüber einer schlitzförmig über den Bildsensor wandernden Belichtung den Vorteil, daß keine Bildverfälschungen durch ungleichzeitige Belichtung der Einzel-Farbbilder entstehen.

Eine vorteilhafte Weiterbildung des erfindungsgemäßen Farb-Bildsensors besteht darin, daß ein Betriebsmodus gewählt werden kann, bei dem die gesamte Belichtungszeit für alle Einzelbilder derart kurz ist, daß die Belichtung eines kompletten Farbbildes innerhalb einer einzigen Beleuchtungsphase eines Kurzzeitbeleuchtungssystems erfolgt. Darüber hinaus ist die Verwendung mehrerer zeitlich aufeinanderfolgender farbiger Einzelblitze in Synchronisation zur Belichtung der Einzelbilder nicht ausgeschlossen Des weiteren können auch steuerbare optische Filterschichten verwendet werden, welche ebenfalls in Synchronisation zur Belichtung der Einzelbilder die auf den Sensor auftreffenden Spektralanteil variieren.

Eine vorteilhafte Weiterbildung des erfindungsgemäßen Farb-Bildsensors besteht darin, daß zur Beleuchtung ein bekannter sogenannter Linearblitz verwendet wird, welcher über Abbrennzeiten von bis zu 20ms bei einer weitgehend zeitlich konstanten Intensität verfügt. Dieses Verfahren eignet sich vor allem dann, wenn aufgrund eventueller transienter Effekte hinsichtlich der Farbdetektoren längere Belichtungszeiten erforderlich sind.

Eine vorteilhafte Weiterbildung des erfindungsgemäßen Farb-Bildsensors besteht darin, daß außer den licht- und farbempfindlichen Detektoren weitere strahlungsempfindliche Elemente in den Sensor eingebracht werden, welche beipielsweise über eine Sensitivität bezüglich des infraroten oder ultravioletten Spektralbereichs verfügen. In diesem Fall können weitere Speicherelemente integriert werden, in denen die den Spektralanteilen außerhalb des sichtbaren Bereichs entsprechenden detektierten Signale gespeichert werden. Hinsichtlich der Betriebsweise des Sensors sowie der zeitlichen Abfolge von Integration, Speicherung und Auslese gelten sinngemäß dieselben Schemata wie für einen ausschließlich im sichtbaren Bereich empfindlichen Sensor.

Eine vorteilhafte Weiterbildung des erfindungsgemäßen Farb-Bildsensors besteht darin, daß die einzelnen Farbkanäle über eine selektive Verstärkung verfügen. Auf diese Weise können unterschiedliche Farbempfindlichkeiten des Detektors kompensiert werden. Selektive Verstärkungen können beispielsweise durch entsprechende Dimensionierung der Integrations- und Speicherkapazitäten oder durch unterschiedliche Wahl der Integrationszeiten bei der Integration der Photoströme realisiert werden.

Eine vorteilhafte Weiterbildung des erfindungsgemäßen Farb-Bildsensors besteht darin, daß eine Farbkorrektur beispielsweise durch die bekannte Maßnahme einer linearen Verknüpfung in Form einer gewichteten Addition der Farbsignale durchgeführt wird. Auf diese Weise kann beispielsweise die spektrale Selektivität der einzelnen Farbkanäle verbessert werden, so daß Farbverfälschungen verringert werden können. Entsprechende elektronische Schaltungen zur Farbkorrektur können innerhalb der Pixelelektronik oder in der peripheren Elektronik des Farb-Bildsensors untergebracht sein.

Eine vorteilhafte Weiterbildung des erfindungsgemäßen Farb-Bildsensors besteht darin, daß die Zahl der Ausleseleitungen an die Anzahl der in jedem Bildpunkt vorhandenen Farbspeicher angepaßt wird, so daß ein zeitgleiches Auslesen aller Farbinformationen vorgenommen werden kann mit dem Ziel, die benötigte gesamte Auslesezeit zu verkürzen.

Eine vorteilhafte Weiterbildung des erfindungsgemäßen Farb-Bildsensors besteht darin, daß der Integratorvorrichtung eine zeitdauersteuernde Vorrichtung zur Bestimmung des Endzeitpunktes der Integrationsdauer zugeordnet ist derart daß höhere Strahlungsintensitäten zu kürzeren und niedrigere Strahlungsintensitäten zu längeren Integrationszeitdauern führen. Zur Steigerung des Dynamikumfanges wird dabei von einer sogenannten globalen oder lokaladaptiven oder lokalautoadaptiven Steuerung der Empfindlichkeit Gebrauch gemacht wird, gemäß dem die Empfindlichkeit jedes Bildpunktes separat an die lokal vorliegende Bildhelligkeit angepaßt wird bzw. sich automatisch anpaßt. In bezug auf die Verwendung dieses Verfahrens in Farbsensoren ist zu beachten, daß die Empfindlichkeitssteuerung für jeden der verschiedenen Farbanteile separat vorgenommen werden muß, wobei gegebenenfalls weitere Speicherelemente in den Sensorpixeln vorzusehen sind.

Eine vorteilhafte Weiterbildung des erfindungsgemäßen Farb-Bildsensors besteht darin, daß der Farb-Bildsensor als Zeilensensor oder als zweidimensionale Pixelmatrix ausgeführt ist. Im Falle einer linearen Sensorstruktur in Form eines Zeilensensors können unter Verwendung der z. Zt. verfügbaren Technologien sehr kleine Pixelgrößen (beispielsweise 10x10µm²) und Pixelabstände (beispielsweise 2µm) realisiert werden, da die Pixelelektronik auch neben den optisch aktiven Bereichen positioniert werden kann.

Eine vorteilhafte Weiterbildung des erfindungsgemäßen Farb-Bildsensors besteht darin, daß auf die lichtempfindliche Schicht weitere optische Elemente integriert werden. Beispielsweise kann eine im Pixelraster strukturierte Anordnung von Mikrolinsen, dazu verwendet werden, eine optische Strahleinkopplung in den Sensor durchzuführen, ohne daß zusätzliche aufwendige Abbildungsoptiken erforderlich wären. Auf diese Weise lassen sich kompakte bildgebende Farbsensoren mit integrierter Abbildungsoptik realisieren (Facettenauge), welche geeignet sind, z. B. im Rahmen von Netzhautimplantaten beim menschlichen Auge (künstliche Retina) eingesetzt zu werden.

Eine weitere bevorzugte Ausführungsform sieht vor, daß jedem Speichermittel eine Vergleichereinrichtung zugeordnet ist, in der ein Referenzsignal für eine vorgebbare Farbe ablegbar ist. Durch diese Variante läßt sich ein sogenannter "Farb-Tracker" erreichen, bei dem als Referenzwert eine bestimmte Farbe vorgegeben wird, beispielsweise ein bestimmter Rotfarbenwert. Tritt nun dieser Farbenwert im ermittelten Bild auf, stellt diese die Vergleichereinrichtung fest und kann eine entsprechende Signalgabe vornehmen.

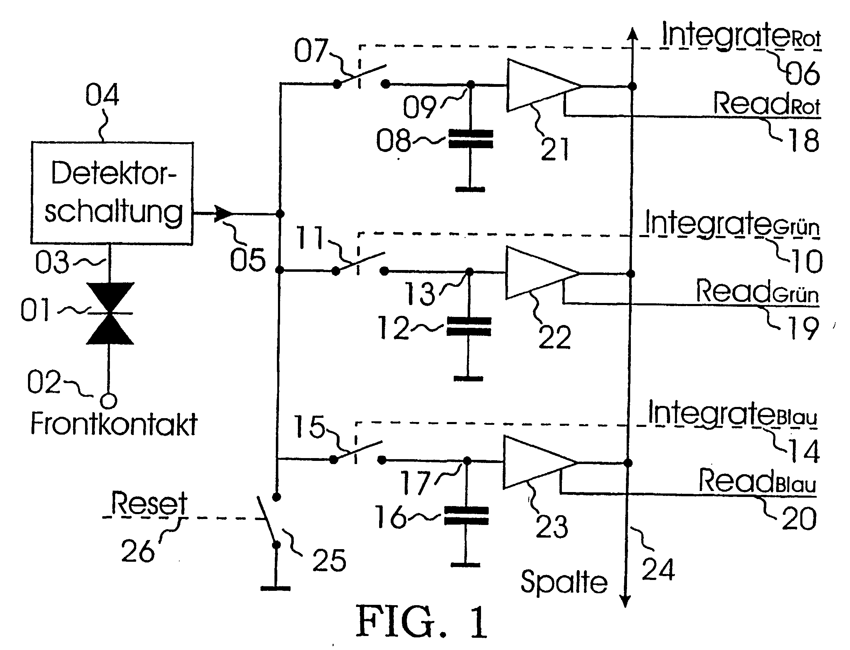

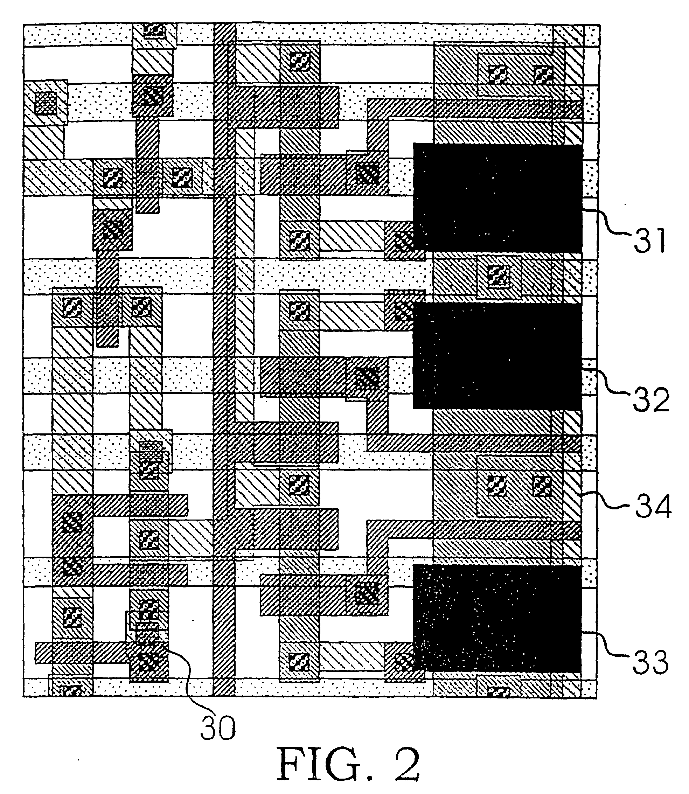

Ein Ausführungsbeispiel der vorstehend beschriebenen Vorrichtung wird in den folgenden Abbildungen dargestellt und näher erläutert. Das Ausführungsbeispiel stellt ein erfindungsgemäßes, in TFA-Technologie realisiertes Pixel für Kurzzeitbelichtung dar. Fig. 1 zeigt das Blockschaltbild der Pixelelektronik für Kurzzeitbelichtung mit den drei Integrationsschaltungen für Rot, Grün und Blau. Fig. 2 zeigt das Layout eines solchen Pixels.

Fig. 1 zeigt das Blockschaltbild eines Pixels für Kurzzeitbelichtung in TFA-Technologie. Über der Pixelschaltung befindet sich der lichtempfindliche und farbselektive Dünnschicht-Detektor 01 aus amorphem Silizium. Dessen Frontkontakt 02 ist für alle Pixel gemeinsam ausgeführt. Der andere Kontakt 03 führt zu der im ASIC realisierten Detektorschaltung 04. Diese Detektorschaltung 04 hält die Spannung am Kontakt 03 des Detektors 01 in jeder der drei Belichtungsphasen auf konstantem Potential und leitet den vom Detektor 01 abgegebenen Photostrom 05 weiter an die rechts abgebildeten Integrationsschaltungen 06 .. 17.

Der Farbdetektor 01 ist so konstruiert, daß seine spektrale Empfindlichkeit durch Wahl der Spannung zwischen seinen Kontakten 02 und 03 zwischen den Farben Rot, Grün und Blau umgeschaltet werden kann. Da die Spannung an Kontakt 03 durch die Detektorschaltung 04 auf konstantem Potential gehalten wird, genügt es, für die Wahl der spektralen Empfindlichkeit die Spannung am Frontkontakt 02 für alle Detektoren gemeinsam auf die entsprechenden Farbspannungen umzuschalten.

Die Kurzzeitbelichtungsphase beginnt damit, daß die Spannung am Frontkontakt 02 so eingestellt wird, daß der Detektor 01 ein Maximum der Spektralempfindlichkeit für rotes Licht aufweist. Sodann schaltet das IntegrateRot-Signal 06 den Integrationsschalter 07 für das Rotsignal ein, und der dem Rotanteil der auf den Bildpunkt auftreffenden Beleuchtung proportionale Photostrom 05 fließt auf den Integrationskondensator 08. Auf dem Kondensator 08 wird ein Spannungssignal 09 aufintegriert, dessen Amplitude proportional zum entsprechenden Photostrom 05 und der gewählten Integrationszeit Trot sowie umgekehrt proportional zum Wert der Kapazität 08 ist. Zum Beenden der Integrationszeit schaltet das IntegrateRot-Signal 06 den Integrationsschalter 07 für den Rotstrom aus, und der Kondensator 08 hält das aufintegrierte Rotsignal 09 fest.

Für die Erzeugung des Grünsignals wird sodann die Spannung am Frontkontakt 02 so eingestellt, daß der Detektor 01 ein Maximum der Spektralempfindlichkeit für grünes Licht aufweist. Nach Verstreichen einer gewissen Einschwingzeit für den Farbdetektor 01, wird analog zum Rotsignal der sich einstellende grünlichtproportionale Photostrom 05 über den Grünstromschalter 11 auf dem Grünsignalkondensator 12 für die Zeit Tgrün aufintegriert, für die das IntegrateGrün-Signal 10 aktiv ist. Das auf dem Grünsignalkondensator 12 aufintegrierte Grünsignal 13 ist wiederum proportional zum Grünstrom 05 und zur Integrationszeit Tgrün und umgekehrt proportional zur Grünkapazität 12.

Schließlich wird analog dazu das Blausignal erzeugt, indem die Spannung am Frontkontakt 02 so eingestellt wird, daß der Detektor 01 ein Maximum für Blaulicht aufweist. Der sich wiederum nach einer gewissen Einschwingzeit einstellende Blaustrom 05 wird über den Blaustromschalter 15 auf dem Blausignalkondensator 16 für die Zeit Tblau auf integriert, für die das IntegrateBlau-Signal 14 aktiv ist. Das auf dem Blausignalkondensator 16 aufintegrierte Blausignal 17 ist proportional zum Blaustrom 05 und zur Integrationszeit Tblau und umgekehrt proportional zur Blaukapazität 16.

Damit ist die Kurzzeitbelichtungsphase abgeschlossen und die intensitätsproportionalen Signale zu den drei Primärfarben Rot, Grün und Blau sind in den Farbkondensatoren 08, 12 und 16 gespeichert. In der nun folgenden Auslesephase schalten nacheinander die Lesesignale ReadRot 18, ReadGrün 19 und ReadBlau 20 die Farbsignale 08, 12 und 16 über die Lesepuffer 21, 22, 23 auf die Spaltenausleseleitung Spalte 24.

Der Bildzyklus schließt ab mit dem Löschen der Farbsignale. Dazu werden der Resetschalter 25 und die Farbstromschalter 07, 11 und 15 durch Aktivieren des Resetsignals 26 und der Integrate-Signale 06, 10 und 14 geschlossen, so daß alle Farbkapazitäten gleichzeitig gelöscht werden. Damit ist das Pixel wieder im Ausgangszustand, und die nächste Integrationsphase kann beginnen.

Fig. 2 zeigt ein Pixellayout, das alle in Fig. 1 skizzierten Pixelfunktionen in CMOS-Technologie realisiert und zusammen mit einem darauf abgeschiedenen farbselektiven Dünnschicht-Detektor in TFA-Technologie hergestellt werden kann. Der Kontakt für den vertikal auf dieser Schaltung abzuscheidenden Detektor 01 ist in Metall2 als 1,6 µm x 1,6 µm großes Rechteck 30 zu sehen. Besonders deutlich hervorgehoben sind die drei Farbkapazitäten 31, 32 und 33, die den Kapazitäten 08; 12 und 16 in Fig. 1 entsprechen. Über die Metall1-Bahn 34 werden die Ausgänge 24 aller Pixel der Spalte an den Spaltenverstärker weitergegeben.

Das Layout wurde in einem 0,6µm-CMOS-Prozess entworfen und belegt mit etwa 16µm x 18µm soviel Platz wie vier nebeneinanderliegende Pixel, die in einem Mosaiksensor für die Generierung der vollen Farbinformation benötigt werden. In einem der schon jetzt verfügbaren, fortschrittlicheren Prozesse (< 0,5µm) würde der Flächenbedarf sogar noch unterboten.

## Patentansprüche

1. Optischer Sensor bestehend aus einer Anordnung von Bildpunkteinheiten, die jeweils einen optoelektronischen Wandler zum Umwandeln der einfallenden Strahlung in einen intensitäts- und wellenlängenabhängigen Photostrom, ein Integratormittel zur Gewinnung eines dem erfaßten Photostrom entsprechenden Meßwertes und ein steuerbares Speichermittel zur Abspeicherung des Meßwertes umfassen und aus einer Auslesesteuereinrichtung für das jeweils auf eine Bildpunkteinheit bezogene Auslesen der abgespeicherten Meßwerte, wobei aus den bildpunkteinheitbezogenen Meßwerten das auf den Sensor eingestrahlte Bild zusammensetzbar ist,
**dadurch gekennzeichnet, daß** der optoelektrische Wandler hinsichtlich seiner spektralen Empfindlichkeit selektiv steuerbar ist, und daß jede Bildpunkteinheit ein Integratormittel (7,8;11,12;15,16) und mindestens zwei parallel zueinander angeordnete Speichermittel (21,22,23) umfaßt derart, daß während der Meßperiodendauer mindestens zwei, jeweils. unterschiedlichen Spektralbereichen der einfallenden Strahlung zugeordnete Meßwerte erfaßbar, abspeicherbar und anschließend gemeinsam zur Bildung der für das Bildpunktelement relevanten Farbinformation auslesbar sind.

2. Optischer Sensor nach Anspruch 1,
**dadurch gekennzeichnet, daß** innerhalb der Meßperiodendauer zeitlich nacheinander die mindestens zwei, jeweils unterschiedlichen Spektralbereichen zugeordneten Meßwerte erfaßt werden.

3. Optischer Sensor nach einem der vorgenannten Ansprüche,
**dadurch gekennzeichnet, daß** der Sensor ein flächiger Sensor ist.

4. Optischer Sensor nach einem der Ansprüche 1 bis 2,
**dadurch gekennzeichnet, daß** der Sensor ein Zeilensensor ist.

5. Optischer Sensor nach einem der vorgenannten Ansprüche,
**dadurch gekennzeichnet, daß** mindestens einer der Spektralbereiche des optoelektronischen Wandlers im Bereich des sichtbaren Lichts liegen.

6. Optischer Sensor nach einem der vorgenannten Ansprüche,
**dadurch gekennzeichnet, daß** mindestens einer der Spektralbereiche des optoelektronischen Wandlers im Infrarot- oder Ultraviolettbereich liegt.

7. Optischer Sensor nach einem der vorgenannten Ansprüche,
**dadurch gekennzeichnet, daß** dem optoelektronischen Wandler (1) ein Analog-Digitalwandler und mindestens zwei digitale Speicher nachgeordnet sind.

## Claims

1. An optical sensor comprising an arrangement of pixel units, each of which comprises an optoelectronic transducer for converting the incident irradiation to an intensity-dependent and wavelength-dependent photo flow, an integrator means for obtaining a measured value which corresponds to that of the acquired photocurrent, and a controllable storage means for storing the measured value; and comprising a read-out control device for reading out, in respect of a pixel unit, the stored measured values, wherein from the pixel-unit-related measured values, the image beamed onto the sensor can be composed,
**characterised in that** the optoelectric transducer in respect of its spectral sensitivity can be selectively controlled, and **in that** each pixel unit comprises an integrator means (7, 8; 11, 12; 15, 16) and at least two storage means (21, 22, 23) arranged in parallel in relation to each other, such that during the duration of the measuring period at least two measuring values, each of which is associated with different spectral regions of the incident irradiation, can be stored and subsequently can be read out together to form the colour information relevant to the pixel element.

2. The optical sensor according to claim 1
**characterised in that** within the duration of the measuring period, the measuring values associated with at least two different spectral regions are acquired in temporal sequence.

3. The optical sensor according to one of the preceding claims,
**characterised in that** the sensor is an area-shaped sensor.

4. The optical sensor according to one of claims 1 to 2,
**characterised in that** the sensor is a line sensor.

5. The optical sensor according to one of the preceding claims,
**characterised in that** at least one of the spectral regions of the optoelectronic transducer is situated in the region of the visible light.

6. The optical sensor according to one of the preceding claims,
**characterised in that** at least one of the spectral regions of the optoelectronic transducer is situated in the infrared region or in the ultraviolet region.

7. The optical sensor according to one of the preceding claims,
**characterised in that** an analog-digital converter and at least two digital storage devices are arranged downstream from the optoelectronic transducer (1).

## Revendications

1. Capteur optique constitué d'un aménagement d'unités de pixels, qui comprennent respectivement un transducteur optoélectronique pour convertir le rayonnement incident en un courant photoélectrique qui est fonction de l'intensité et de la longueur d'onde, un moyen d'intégration pour obtenir une valeur de mesure correspondant au courant photoélectrique détecté et un moyen de mémorisation commandable pour mémoriser la valeur de mesure, et d'un dispositif de commande de lecture pour la lecture des valeurs de mesure mémorisées en rapport avec respectivement une unité de pixels, l'image incidente sur le capteur pouvant être composée des valeurs de mesure rapportées à l'unité de pixels, **caractérisé en ce que** le transducteur optoélectronique peut être commandé sélectivement en termes de sensibilité spectrale et **en ce que** chaque unité de pixels comprend un moyen d'intégration (7, 8; 11, 12; 15, 16) et au moins deux moyens de mémorisation (21, 22, 23) agencés en parallèle l'un avec l'autre de sorte que, pendant la durée de mesure, au moins deux valeurs de mesure affectées à respectivement différentes plages spectrales du rayonnement incident puissent être détectées, mémorisées et, ensuite, lues conjointement pour la formation des informations de couleurs importantes pour l'élément de pixels.

2. Capteur optique selon la revendication 1, **caractérisé en ce que**, pendant la durée de mesure, les au moins deux valeurs de mesure respectivement à différentes plages spectrales sont détectées l'une après l'autre dans le temps.

3. Capteur optique selon l'une quelconque des revendications précédentes, **caractérisé en ce que** le capteur est un capteur plat.

4. Capteur optique selon l'une quelconque des revendications 1 à 2, **caractérisé en ce que** le capteur est un capteur de lignes.

5. Capteur optique selon l'une quelconque des revendications précédentes, **caractérisé en ce qu'**au moins l'une des plages spectrales du transducteur optoélectronique se situe dans la plage de la lumière visible.

6. Capteur optique selon l'une quelconque des revendications précédentes, **caractérisé en ce qu'**au moins l'une des plages spectrales du transducteur optoélectronique se situe dans la plage infrarouge ou ultraviolette.

7. Capteur optique selon l'une quelconque des revendications précédentes, **caractérisé en ce qu'**un convertisseur analogique-numérique et au moins deux mémoires numériques sont agencés en aval du transducteur optoélectronique (1).
